**Europäisches Patentamt**

**European Patent Office**

**Office européen des brevets**

(19)

(11) Publication number : **0 433 383 B1**

## (12) EUROPEAN PATENT SPECIFICATION

(45) Date of publication of patent specification :
**26.10.94 Bulletin 94/43**

(51) Int. Cl.⁵ : **G11C 27/02, H03F 1/30**

(21) Application number : **89910770.0**

(22) Date of filing : **11.09.89**

(86) International application number :
**PCT/US89/03919**

(87) International publication number :
**WO 90/03034 22.03.90 Gazette 90/07**

(54) **SAMPLE-HOLD AMPLIFIER CIRCUIT.**

(30) Priority : **09.09.88 US 242886**

(43) Date of publication of application :
**26.06.91 Bulletin 91/26**

(45) Publication of the grant of the patent :
**26.10.94 Bulletin 94/43**

(84) Designated Contracting States :
**DE FR GB**

(56) References cited :
**US-A- 4 604 584**
**Electrical Design News, vol. 32, no. 10, 14 May 1987, (Newton, MA, US), P. Henry "JFET-input amps are unrivaled for speed and accuracy", pages 161-169**
**Electronics Letters, vol. 24, no. 5, 3 March 1988, (Stevenage, Herts., GB), L. Kunsagi et al. "Buffer-based switched-capacitor gain stages", pages 254-255**

(73) Proprietor : **ANALOG DEVICES, INCORPORATED**
**Route 1**
**Industrial Park**
**Norwood, MA 02062 (US)**

(72) Inventor : **MILLER, Gerald**
**24 Beechwood Road**
**Hudson, NH 03051 (US)**
Inventor : **O'CONNOR, Christopher**
**1968 Southeast 72nd Court**
**Hillsboro, OREGON (US)**

(74) Representative : **Warren, Anthony Robert et al**
**BARON & WARREN,**
**18 South End,**
**Kensington**
**London W8 5BU (GB)**

## Description

The present invention relates to the field of data-acquisition systems, and more specifically to sample-hold (or sample-and-hold) amplifiers (SHAs). The present invention provides an auto-zeroing sample-hold amplifier that inherently corrects for internal amplifier errors.

Sample-hold amplifiers are well known in the electronics industry. As the name implies, a sample-hold amplifier has two steady-state operating modes. In the sample-, or track-, mode, the output of an SHA tracks the input as precisely as possible until the hold-mode is initiated. In the hold-mode, the output of the SHA retains the value of the input signal at the time the hold-mode was initiated.

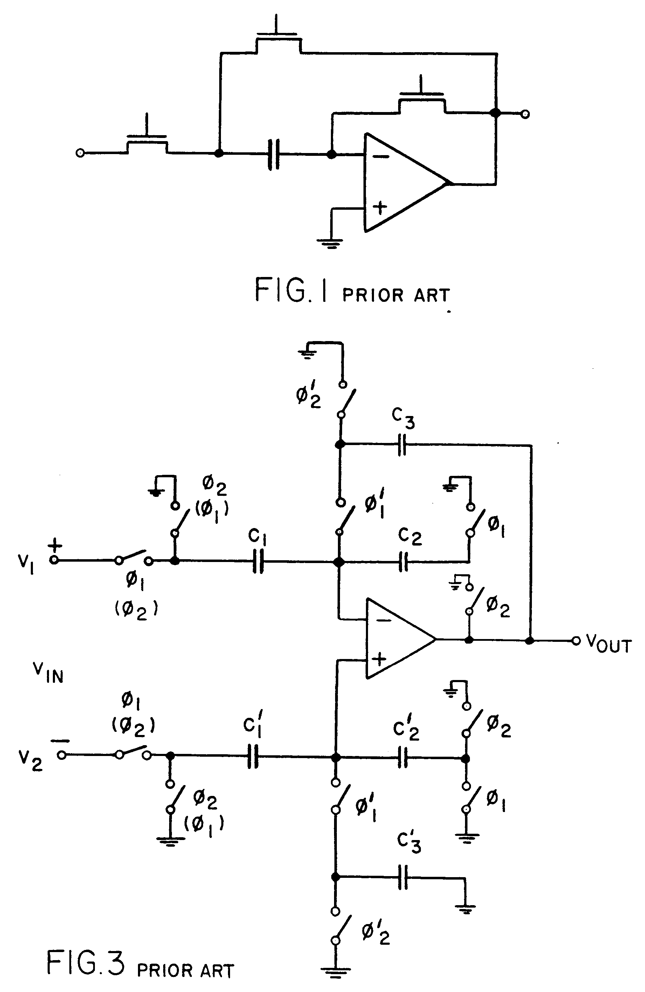

Although few circuit components are required for a basic sample-hold amplifier, accurate holding of the sampled input voltage requires a more sophisticated architecture. Figs. 1, 2, 3 and 4 illustrate some exemplary prior art embodiments of sample-hold amplifiers; many others exist. These exemplary prior art sample-hold circuits employ the technique of auto-zeroing to reduce output errors due to input offsets. In sample-hold applications, auto-zeroing is a method of compensating for errors introduced by the voltage offsets of amplifiers within the circuit. Typically, the offset error of a transconductance amplifier is sampled in the sample-mode of operation. A similar offset value is then added to the output voltage in the hold-mode to negate the offset error. In the prior art circuits listed above, auto-zeroing is used to force the output voltage of the circuit to equal the sampled input voltage. The architecture and performance of these circuits, however, have undesirable drawbacks which limit their utility.

Fig. 1 is a schematic diagram of a simplified auto-zeroing sample-hold amplifier. This sample-hold amplifier requires a high gain/low offset transconductance amplifier and exhibits poor settling behavior from the return to zero requirement at the circuit output.

Fig. 2 is a schematic diagram of an auto-zeroing sample-hold amplifier which is capable of simultaneous acquisition of an analog signal and storage of a previously sampled signal. This sample-hold amplifier exhibits poor dynamic behavior, requires a high gain/low offset output amplifier and is too complex to be implemented monolithically. Furthermore, the output of the sample-hold amplifier does not track the voltage input.

Fig. 3 is a schematic diagram of a differential switched-capacitor amplifier which contains amplifier offset voltage cancellation. As with the SHA of Fig. 2, this amplifier exhibits poor dynamic behavior, requires a high gain amplifier, and the amplifier output does not track the voltage input.

Fig. 4 is a schematic diagram of an auto-zeroing sample-hold amplifier which exhibits good circuit performance but, as with the SHA of Fig. 2 is unduly complex.

It is therefore an object of the present invention to provide a sample-hold amplifier for use in sampling analog signals, which is capable of correcting internal amplifier offset and gain errors, without the need for the amplifier output to return to zero.

Another object of the present invention is to provide a sample-hold amplifier in which the circuit output tracks the voltage input.

According to the present invention, there is provided a sample-hold amplifier circuit as defined in claim 1.

In the sample-hold amplifier circuit embodying the present invention, the circuit output tracks the voltage input, and, in response to a command signal, samples and accurately holds the sampled input voltage at the amplifier output. Both the input and the output are buffered, and the input voltage is sampled not only across primary charge storage means comprising a primary "hold" capacitor, but also across secondary charge storage means comprising a secondary "hold" capacitor at the output of the amplifier, so as to reduce voltage excursions at the output of the circuit due to buffer offsets. The input and output buffers introduce complementary, equal magnitude offset voltages which, together with a unique feedback arrangement to control charging of the output amplifier capacitor, enables auto-zeroing of internal amplifier offset errors.

The sample-hold amplifier circuit embodying the invention includes an input switch, a feedback switch, primary and secondary sampling switches, input and output buffers, primary and secondary hold capacitors, a compensation capacitor, and a transconductance amplifier.

The sample-hold amplifier circuit operates in two modes, the sample-mode and the hold-mode.

During the sample-mode, the input switch, and the primary and secondary sampling switches are closed. The feedback switch is open. The transconductance amplifier provides the primary and secondary hold capacitors with a virtual ground, enabling the circuit output to track the voltage input through a signal path defined by the input buffer, the secondary sampling switch, and the output buffer. When a Hold command is asserted, a transition from the sample-mode to the hold-mode is initiated. First, the primary sampling switch is opened, causing the input voltage to be sampled across the primary hold capacitor. Next, the secondary sampling switch is opened, causing the input voltage to be sampled across the secondary hold capacitor. Finally, the input switch is opened, disconnecting the entire circuit from the input voltage, and the feedback switch is closed, completing the feedback loop around the transconductance amplifier. The circuit is now in the hold-mode.

In the hold-mode, the transconductance amplifier provides some voltage gain, with a negative feedback loop which includes, in series, the secondary hold capacitor, the output buffer, the feedback switch, the input buffer, and the primary hold capacitor. Assuming ideally that the input and output buffers and the transconductance amplifier have no offset voltages, the exact input voltage is held on the primary and secondary hold capacitors. Upon entering the hold-mode, the output voltage of the circuit would automatically equal the sampled input voltage stored on the primary and secondary hold capacitors without any error compensation required of the transconductance amplifier. Realistically, the voltage offsets from the input buffer and transconductance amplifier will be sampled onto the primary hold capacitor along with the input voltage. Once in the hold-mode, the transconductance amplifier forces the output voltage to equal the sampled input voltage, by correcting any offset errors.

The sample-hold amplifier circuit embodying the invention uses simple low precision amplifiers which do not require high gain or low offsets. It has a fast acquisition time, a low power consumption, and requires little area for integration.

The invention will be more fully understood from the detailed description set forth below, which should be read in conjunction with the accompanying drawings, in which:-

Fig. 1 is a schematic circuit diagram for a prior art implementation of an auto-zeroing sample-hold amplifier;

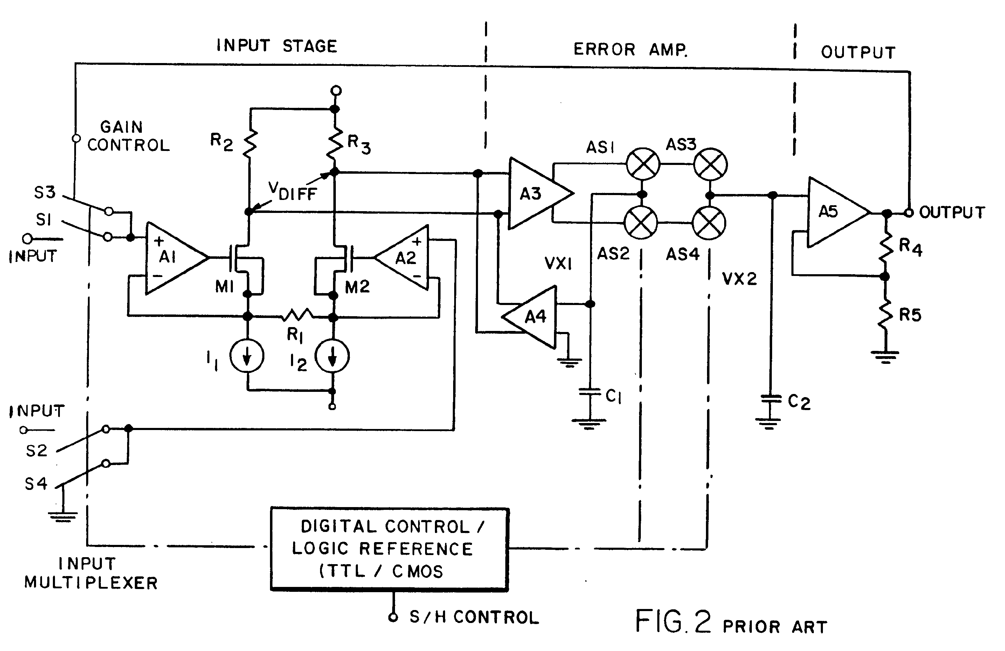

Fig. 2 is a schematic circuit diagram for a prior art auto-zeroing sample-hold amplifier which is capable of simultaneously sampling an analog signal which storing the previously sampled signal;

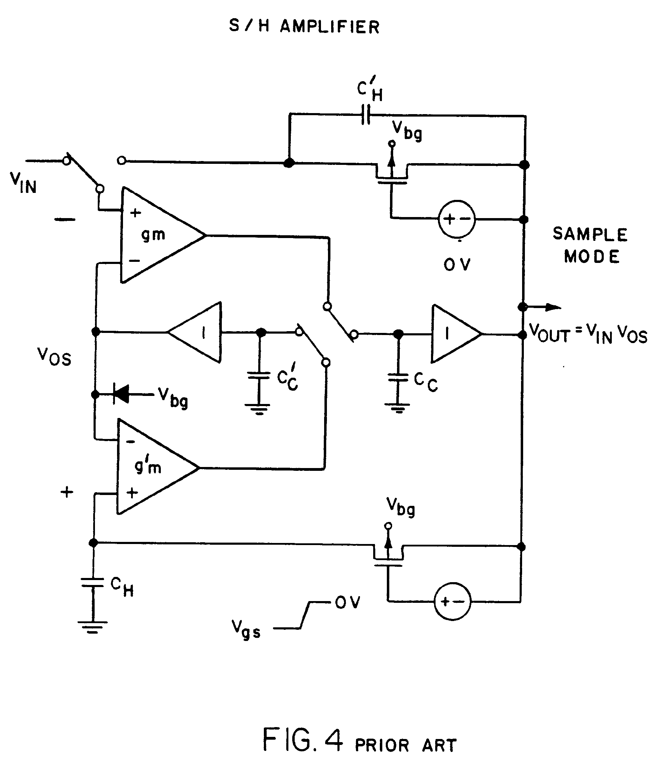

Fig. 3 is a schematic circuit diagram of a prior art differential switched-capacitor amplifier;

Fig. 4 is a schematic circuit diagram for yet another embodiment of a prior art sample-hold amplifier;

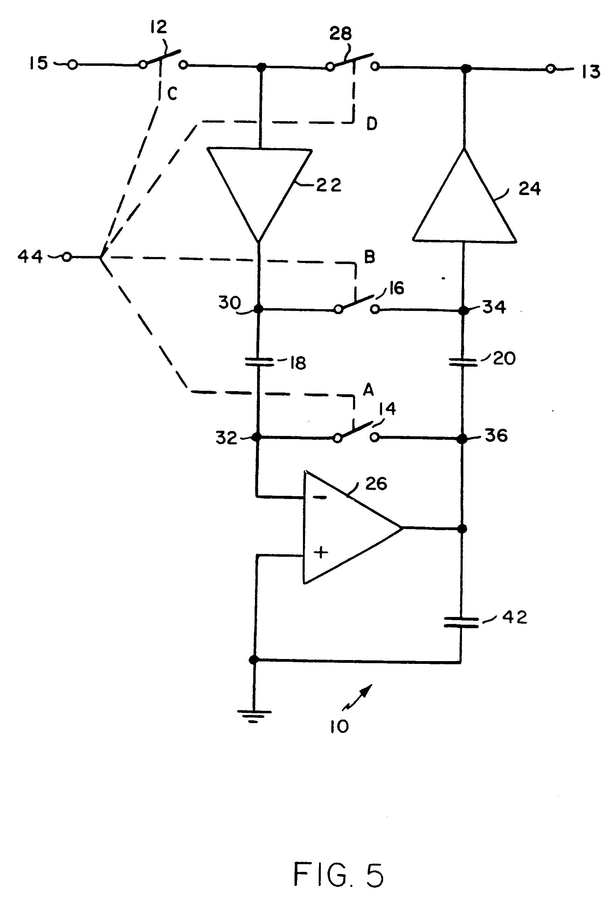

Fig. 5 is a schematic circuit diagram of the fundamental embodiment of the sample-hold amplifier of the present invention;

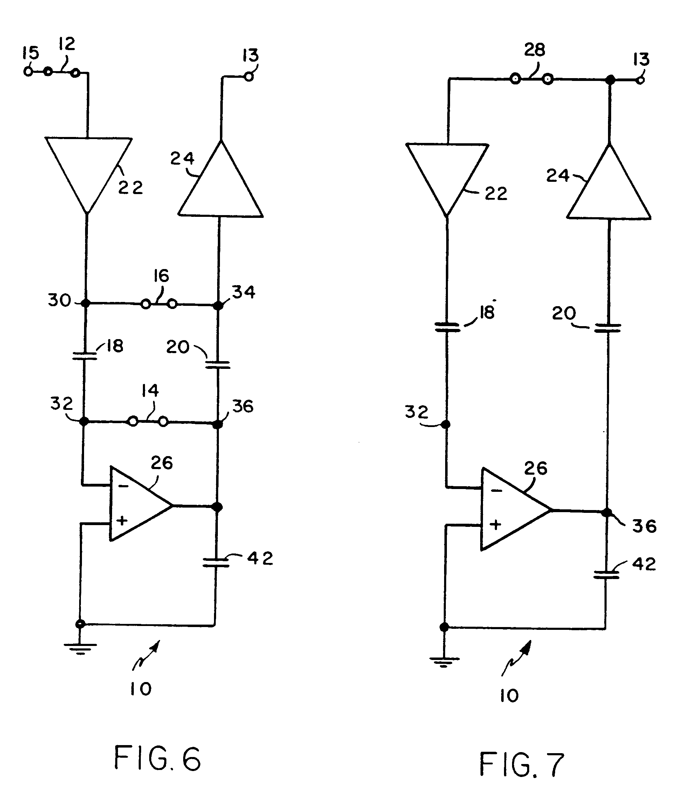

Fig. 6 is a schematic circuit diagram illustrating the configuration of the sample-hold amplifier of Fig. 5 in the sample-mode of operation;

Fig. 7 is a schematic circuit diagram illustrating the conceptual configuration of the sample-hold amplifier of Fig. 5 in the hold-mode of operation;

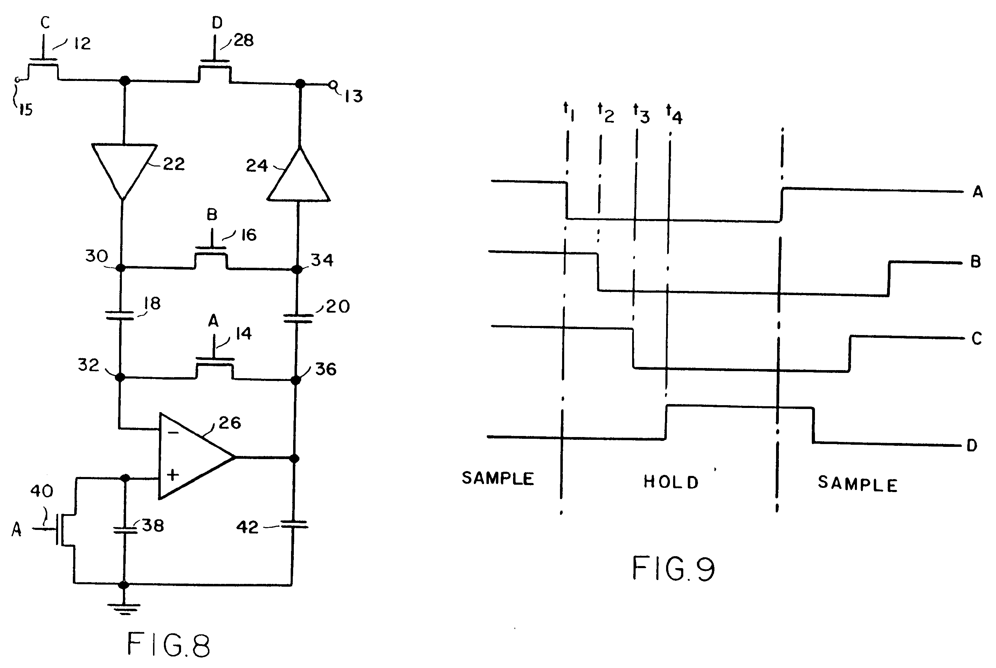

Fig. 8 is a schematic circuit diagram of a more complete architecture of the sample-hold amplifier of Fig. 5 including additional circuitry for cancellation of injection charges; and

Fig. 9 is timing diagram illustrating the signal levels of various control signals used to control the modes of the sample-hold amplifier embodying the present invention.

Referring to the drawings, and in particular Fig. 5, a basic implementation of an improved sample-hold amplifier 10 is shown. SHA 10 comprises input terminal 15, output terminal 13, control terminal 44, input switch 12, input buffer 22, output buffer 24, primary sample switch 14, secondary sample switch 16, primary hold capacitor 18, secondary hold capacitor 20, feedback switch 28, compensation capacitor 42, and transconductance amplifier 26.

The input switch 12 is connected between the input terminal 15 and the input of input buffer 22. The output of input buffer 22 is connected to a first electrode of primary hold capacitor 18; the second electrode of capacitor is connected to the inverting input terminal of amplifier 26. The output terminal of amplifier 26 is connected to a first electrode of secondary hold capacity 20; the second electrode of capacitor 20 is, in turn, connected to the input of output buffer 24. The output of output buffer 24 provides, at terminal 13, the output of the sample-hold amplifier circuit 10.

The non-inverting terminal of amplifier 26 is connected to ground. The output terminal of amplifier 26 is also connected to a first electrode of compensation capacitor 42; the second electrode of compensation capacitor 42 is connected to ground. The Sample/Hold command signal is applied to control terminal 44, and in response, appropriate control signals (see Fig. 9) are supplied to the switches by control circuitry which is not shown but which will be obvious to electrical engineers. The control signals, shown in dotted lines on Fig. 5, which dictate the state of switches 14, 16, 12, and 28, are designated as A, B, C, and D, respectively.

Switches 14, 16, and 28 are further included for reconfiguring sample-hold amplifier 10. Primary sample switch 14 is connected between the inverting input terminal and output terminal of transconductance amplifier 26. Secondary sampling switch 16 is connected across the output of input buffer 22 and the input of output buffer 24. Finally, feedback switch 28 is connected between the input of input buffer 22 and the output of output buffer 24.

Sample-hold amplifier 10 has two steady-state modes of operation, the sample-mode and the hold-mode. A discussion of each mode of operation follows. To facilitate the explanation of the circuit's operation, several nodes in the circuit are given reference numerals.

Fig. 6 illustrates the configuration of the sample-hold amplifier 10 of Fig. 5 in the sample-mode of operation. In the sample-mode, the Sample/Hold signal applied to control terminal 44 is high. Feedback switch 28 is in the open position. Input switch 12, primary sampling switch 14 and secondary sampling switch 16 are closed. Input switch 12 connects the sample-hold amplifier 10 to the input voltage.

In the sample-mode configuration, the voltage output of sample-hold amplifier 10 tracks the voltage input through the signal path comprised of input terminal 15, input switch 12, input buffer 22, secondary sampling switch 16, output buffer 24, and output terminal 13. Amplifier 26, in the sample-mode, acts as a transconductance amplifier which, with its non-inverting terminal tied to ground, ideally appears to the "bottom" electrodes of primary hold capacitor 18 and secondary hold capacitor 20 as a virtual ground. Realistically, because transconductance amplifier 26 is in a feedback configuration via primary sampling switch 14, an offset voltage will appear at the inverting terminal of the transconductance amplifier, thereby forcing the voltage at nodes 32 and 36 to equal the offset voltage of transconductance amplifier. Nodes 30 and 34 are driven by input buffer 22 to a voltage equal to the input voltage minus an offset value for buffers 22 and 24.

A transition of the signal at control terminal 44 from high to low initiates the transition of sample-hold amplifier 10 from the sample-mode to the hold-mode. Fig. 9 is a timing diagram illustrating the control signals used to reconfigure the circuit. At time $t_1$, conincident with the high-to-low transition of control signal A, primary sampling switch 14 is opened. At the instant that primary sampling switch 14 is opened, a charge is trapped on primary hold capacitor 18, and the voltage at node 30 is sampled across the capacitor. At time $t_2$, coincident with the high-to-low transition of control signal B, secondary sampling switch 16 is opened. The instant secondary sampling switch 16 is opened, a charge is trapped on secondary hold capacitor 20, and the voltage present at node 34 is sampled across the secondary hold capacitor. The voltages sampled across the primary and secondary hold capacitors is equal to the input voltage plus some offset errors.

The offset voltage of an amplifier is defined as the residual voltage to which a potential difference between the input terminals of the amplifier is driven by negative feedback and is designated as $V_{os}$. The input voltage to SHA 10 is designated as $V_{in}$. Where the offset voltages for input buffer 22, output buffer 24 and amplifier 26 are designated as $V_{os1}$, $V_{os2}$, and $V_{os3}$ respectively, the sampled input voltage across primary hold capacitor 18 ($V_{CH}$) equals:

$$V_{CH} = V_{in} + V_{os1} - V_{os3} \quad (1)$$

Once the input voltage is sampled across primary hold capacitor 18 and secondary hold capacitor 20, the sample-hold amplifier can be disconnected from the input voltage and reconfigured to compensate for offset errors. Accordingly, at time $t_3$, coincident with the high-to-low transition of control signal C, input switch 12 is opened, thereby disconnecting sample-hold amplifier 10 from the input voltage at input terminal 15. At time $t_4$, coincident with the low-to-high transition of control signal B, feedback switch 28 is closed, completing the transition of sample-hold amplifier 10 from the sample-mode to the hold-mode.

Fig. 7 illustrates the configuration of the sample-hold amplifier of Fig. 5 in the hold-mode of operation. In the hold-mode, the feedback loop of transconductance amplifier 26 includes secondary hold capacitor 20, output buffer 24, feedback switch 28, input buffer 22, and primary hold capacitor 18. In the hold-mode, amplifier 26 changes its function from a transconductance amplifier to a voltage amplifier, to compensate for offset voltages from itself and the input and output buffers.

Assuming ideally that amplifier 26, input buffer 22 and output buffer 24 had zero offset voltages, then the voltage sampled across primary hold capacitor 18 and secondary hold capacitor 20 would be exactly equal to the input voltage at the time of sampling. Upon opening the input switch and closing the feedback switch, the output voltage will equal the input voltage without any compensation or level-shifting required of the voltage amplifier 26.

Realistically, offset voltages are introduced into the voltage sampled across the primary and secondary hold capacitors, as shown by equation 1. The voltage errors sampled along with the input voltage are now subtracted in the hold-mode loop. In the hold-mode, the output voltage is required to change an amount equal to the sum of the offset voltages of input buffer 22 and output buffer 24.

Where $A_v$ equals the gain of voltage amplifier 26, the inverting input of voltage amplifier 26 is required to move voltage error amount ($V_E$) equal:

$$V_E = (V_{os1} + Vos2)/A_v \quad (2)$$

By designing input buffer 22 and output buffer 24 with complementary offset voltages of equal magnitude, the voltage error $V_E$ can be made negligibly small. When $V_E$ is negligible, little movement is required of voltage amplifier 26 which forces the output voltage of sample-hold amplifier 10 to equal the sampled input voltage.

Assuming that no charge injection error is introduced onto the primary hold capacitor 18 by input switch 12, a sample-hold amplifier 10, built as described above, can, to the first order, sample and hold exact input voltages. Realistically, second order effects such as charge injection errors will modify the performance of the present invention.

Referring now to Fig. 8, a more complete architecture useful for implementing sample-hold amplifier 10 is illustrated. A cancellation switch 40 and cancellation capacitor 38 are connected in parallel between the non-inverting input terminal of transconductance amplifier 26 and ground. By simultaneously controlling cancellation switch 40 and primary sampling switch 14 with control signal A, the voltage errors caused by switch charge feed-through onto the primary hold capacitor 18 may be differentially cancelled. A dominant pole compensation capacitor 42 is further included in FIG. 8. Upon opening of primary and secondary sampling switches node 36 is prevented from moving quickly by compensation capacitor 42, insuring that the sample on the secondary hold capacitor will approximate the sample on the primary hold capacitor if the interval between the samples is short. Compensation capacitor 42 further prevents the transconductance amplifier 26 from oscillating. The switches of sample-hold amplifier 10 are implementing with MOS transistors in Fig. 8, whereas they are simply shown by the functional switch symbol in Figs. 5, 6 and 7 without regard to implementation details.

In the preferred embodiment, sample-hold amplifier 10 is implemented monolithically using a BiCMOS fabrication process. In the preferred embodiment, all switches are implemented with PMOS-NMOS pairs, except for the primary sampling switch 14 and cancellation switch 40, which are NMOS devices of small size for reduced charge feed-through. When implemented monolithically, as many as four independently controlled sample-hold amplifiers may be fabricated onto a chip with each sample-hold amplifier occupying less than 2300 square mils.

An auto-zeroing sample-hold amplifier 10, constructed as described above, is capable of tracking an input voltage and, when indicated, sampling and accurately holding an input voltage without significant gain or offset errors. Furthermore, the present invention can be implemented monolithically to achieve acquisition times of 500 nanoseconds, power consumption of 75 mW, and space consumption of less than 2300 sq. mils.

Having thus described one particular embodiment, various alterations, modifications and improvements will readily occur to those skilled in the art. Accordingly, the foregoing description is intended to be exemplary only, and limited only as defined in the following claims.

**Claims**

1.  A sample-hold amplifier circuit (10) for sampling a voltage applied to an input (15) of the circuit and for selectively holding the sampled input voltage to provide the same to an output (13) of the circuit, said circuit including:
    an amplifier (26), having an output terminal, an inverting input terminal, and a non-inverting input terminal;
    primary charge storage means (18), for storage of said sampled input voltage, having a first lead, and a second lead connected to the inverting input terminal of the amplifier (26); and
    a primary sampling switch (14) connected between the inverting input terminal and the output terminal of the amplifier (26);
    characterised by:

an input buffer (22), having an output terminal, and an input terminal attached to said input (15) of the circuit (10), for driving said input voltage to the remainder of the circuit;
    the first lead of the primary charge storage means (18) being connected to the output terminal of said input buffer;
    the non-inverting input terminal of the amplifier (26) being attached to ground;
    secondary charge storage means (20) having a first lead attached to the output terminal of said amplifier (26);
    an output buffer (24) having an input terminal connected to a second lead of the secondary charge storage means (20), and an output terminal providing the output for said circuit (10);
    a secondary sampling switch (16) connected between the output terminal of the input buffer (22) and the input terminal of the output buffer (24); and
    a feedback switch (28) connected between the input terminal of the input buffer (22) and the output terminal of the output buffer (24).

2.  A sample-hold amplifier circuit as claimed in claim 1, in which said input buffer (22) and said output buffer (24) have complementary offset voltages of equal magnitude.

3.  A sample-hold amplifier circuit as claimed in claim 1 or 2, in which said primary charge storage means (18) is a capacitor.

4.  A sample-hold amplifier circuit as claimed in claim 1, 2 or 3, in which said secondary charge storage means (20) is a capacitor.

**Patentansprüche**

1.  Abtast-Halte-Verstärkerschaltung (10) zum Abtasten einer an einen Eingang (15) der Schaltung gelegten Spannung und zum selektiven Halten der abgetasteten Eingangsspannung, um diese an einem Ausgang (13) der Schaltung bereitzustellen, wobei die Schaltung folgendes enthält:
    einen Verstärker (26) mit einem Ausgangsanschluß, einem invertierenden Eingangsanschluß und einem nicht invertierenden Eingangsanschluß;
    eine primäre Ladungsspeicherungseinrichtung (18) zur Speicherung der abgetasteten Eingangsspannung mit einem ersten und einem zweiten Leiter, welche mit dem invertierenden Eingangsanschluß des Verstärkers (26) gekoppelt sind; und
    einen zwischen dem invertierenden Eingangsanschluß und dem Ausgangsanschluß des Verstärkers (26) eingeschalteten primären Abtastschalter (14);

gekennzeichnet durch:

einen Eingangspuffer (22) mit einem Ausgangs- und einem Eingangsanschluß, welche mit dem Eingang (15) der Schaltung (10) zum Aussteuern der Eingangsspannung für die restliche Schaltung gekoppelt sind;

wobei der erste Leiter der primären Ladungsspeicherungseinrichtung (18) mit dem Ausgangsanschluß des Eingangspuffers gekoppelt ist;

der nicht invertierende Eingangsanschluß des Verstärkers (26) an Masse gelegt ist;

ein Leiter einer sekundären Ladungsspeicherungseinrichtung (20) am Ausgangsanschluß des Verstärkers (26) angeschlossen ist;

ein Eingangsanschluß eines Ausgangspuffers (24) mit einem zweiten Leiter der sekundären Ladungsspeicherungseinrichtung (20) gekoppelt ist und ein Ausgangsanschluß den Ausgang dieser Schaltung (10) bereitstellt;

ein sekundärer Abtastschalter (16) zwischen dem Ausgangsanschluß des Eingangspuffers (22) und dem Eingangsanschluß des Ausgangspuffers (24) eingeschaltet ist; und

ein Rückkopplungsschalter (28) zwischen dem Eingangsanschluß des Eingangspuffers (22) und dem Ausgangsanschluß des Ausgangspuffers (24) eingeschaltet ist.

2. Abtast-Halte-Verstärkerschaltung nach Anspruch 1, in welcher der Eingangspuffer (22) und der Ausgangspuffer (24) komplementäre Offsetspannungen gleicher Größe aufweisen.

3. Abtast-Halte-Verstärkerschaltung nach Anspruch 1 oder 2, in welcher die primäre Ladungsspeicherungseinrichtung (18) ein Kondensator ist.

4. Abtast-Halte-Verstärkerschaltung nach Anspruch 1, 2 oder 3, in welcher die sekundäre Ladungsspeicherungseinrichtung (20) ein Kondensator ist.

**Revendications**

1. Circuit amplificateur échantillonneur-bloqueur (10) pour échantillonner une tension appliquée à une entrée (15) du circuit et pour maintenir sélectivement la tension d'entrée échantillonnée afin de fournir la même à une sortie (13) du circuit, ledit circuit comprenant :

un amplificateur (26), ayant une borne de sortie, une borne d'entrée inverseuse, et une borne d'entrée non inverseuse ;

des moyens primaires de stockage de charge (18) pour le stockage de ladite tension d'entrée appliquée, ayant un premier fil, et un second fil connecté à la borne d'entrée inverseuse de l'amplificateur (26) ; et

un interrupteur d'échantillonnage primaire (14) connecté entre la borne d'entrée inverseuse et la borne de sortie de l'amplificateur (26) ;

caractérisé par :

un tampon d'entrée (22), ayant une borne de sortie, et une borne d'entrée reliée à ladite sortie (15) du circuit (10) pour véhiculer ladite tension d'entrée au restant du circuit ;

le premier fil des moyens primaires de stockage de charge (18) étant connecté à la borne de sortie dudit tampon d'entrée ;

la borne non-inverseuse de l'amplificateur (26) étant reliée à la masse ;

des moyens secondaires de stockage de charge (20) ayant un premier fil relié à la borne de sortie dudit amplificateur (26) ;

un tampon de sortie (24) ayant une borne d'entrée connectée à un second fil des moyens secondaires de stockage de charge (20) ; et

une borne de sortie fournissant la sortie pour ledit circuit (10) ;

un interrupteur secondaire d'échantillonnage (16) connecté entre la borne de sortie du tampon d'entrée (22) et la borne d'entrée du tampon de sortie (24) ; et

un interrupteur rétroactif (28) connecté entre la borne d'entrée du tampon d'entrée (22) et la borne de sortie du tampon de sortie (24).

2. Circuit amplificateur échantillonneur-bloqueur selon la revendication 1, dans lequel ledit tampon d'entrée (22) et ledit tampon de sortie (24) ont des tensions offset complémentaires de même amplitude.

3. Circuit amplificateur échantillonneur-bloqueur selon la revendication 1 ou la revendication 2, dans lequel lesdits moyens primaires de stockage de charge (18) consistent en un condensateur.

4. Circuit amplificateur échantillonneur-bloqueur selon la revendication 1, 2 ou 3, dans lequel lesdits moyens secondaires de stockage de charge (20) consistent en un condensateur.

FIG. 1 PRIOR ART

FIG. 3 PRIOR ART

7

FIG. 2 PRIOR ART

INPUT STAGE

ERROR AMP.

OUTPUT

GAIN CONTROL

INPUT MULTIPLEXER

DIGITAL CONTROL / LOGIC REFERENCE (TTL / CMOS

S/H CONTROL

EP 0 433 383 B1

## S/H AMPLIFIER

FIG. 4 PRIOR ART

FIG. 5

FIG. 6

FIG. 7

FIG.8

FIG.9

EP 0 433 383 B1